(19) Europäisches Patentamt / European Patent Office / Office européen des brevets

(11) **EP 2 660 938 B1**

(12) **FASCICULE DE BREVET EUROPEEN**

(45) Date de publication et mention
de la délivrance du brevet:
**08.04.2015 Bulletin 2015/15**

(51) Int Cl.:
*H01S 1/02* (2006.01)       *H01S 5/06* (2006.01)
*H01S 5/10* (2006.01)       *G02F 1/35* (2006.01)

(21) Numéro de dépôt: **13165779.3**

(22) Date de dépôt: **29.04.2013**

(54) **Dispositif laser d'émission d'onde Térahertz à structure trouée**

Laservorrichtung mit gelochter Struktur, die Terahertz-Wellen ausstrahlt

Laser device with terahertz wave emission with holed structure

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.04.2012 FR 1253986**

(43) Date de publication de la demande:
**06.11.2013 Bulletin 2013/45**

(73) Titulaire: **COMMISSARIAT A L'ENERGIE ATOMIQUE ET AUX ENERGIES ALTERNATIVES**
**75015 Paris (FR)**

(72) Inventeurs:
• **Gerard, Jean-Michel**
  **38410 SAINT MARTIN D'URIAGE (FR)**
• **Claudon, Julien**
  **38950 SAINT MARTIN LE VINOUX (FR)**
• **Leo, Giuseppe**
  **94120 Fontenay SOUS BOIS (FR)**
• **Andronico, Alessio**
  **75012 PARIS (FR)**
• **Munsch, Mathieu**
  **68100 MULHOUSE (FR)**

(74) Mandataire: **Lebkiri, Alexandre**
**Cabinet Camus Lebkiri**
**25, Rue de Maubeuge**
**75009 Paris (FR)**

(56) Documents cités:
**WO-A1-2009/150341**

• **MUNSCH M ET AL: "Room temperature, continuous wave lasing in microcylinder and microring quantum dot laser diodes", APPLIED PHYSICS LETTERS, AIP, AMERICAN INSTITUTE OF PHYSICS, MELVILLE, NY, US, vol. 100, no. 3, 16 janvier 2012 (2012-01-16), pages 31111-31111, XP012156848, ISSN: 0003-6951, DOI: 10.1063/1.3678031 [extrait le 2012-01-20]**
• **ANDRONICO A ET AL: "Integrated terahertz source based on three-wave mixing of whispering-gallery modes", OPTICS LETTERS, OSA, OPTICAL SOCIETY OF AMERICA, WASHINGTON, DC, US, vol. 33, no. 21, 1 novembre 2008 (2008-11-01), pages 2416-2418, XP001519524, ISSN: 0146-9592, DOI: 10.1364/OL. 33.002416**
• **A. ANDRONICO ET AL: "<title>Quantum-dot based nonlinear source of THz radiation</title>", PROCEEDINGS OF SPIE, vol. 8119, 8 septembre 2011 (2011-09-08), pages 81190C-81190C-6, XP055053561, ISSN: 0277-786X, DOI: 10.1117/12.901202**
• **ANDRONICO A ET AL: "Difference frequency generation in GaAs microdisks", OPTICS LETTERS, OSA, OPTICAL SOCIETY OF AMERICA, WASHINGTON, DC, US, vol. 33, no. 18, 15 septembre 2008 (2008-09-15), pages 2026-2028, XP001516876, ISSN: 0146-9592, DOI: 10.1364/OL.33.002026**
• **FASCHING G ET AL: "Microcavity THz quantum cascade laser", PHYSICA E - LOW-DIMENSIONAL SYSTEMS AND NANOSTRUCTURES, ELSEVIER SCIENCE BV, NL, vol. 32, no. 1-2, 1 mai 2006 (2006-05-01), pages 316-319, XP028038551, ISSN: 1386-9477, DOI: 10.1016/J.PHYSE.2005.12.073 [extrait le 2006-05-01]**

EP 2 660 938 B1

- ADAM T N ET AL: "The design and fabrication of microdisk resonators for terahertz frequency operation", PROCEEDINGS IEEE LESTER EASTMAN CONFERENCE ON HIGH PERFORMANCE DEVICES. NEWARK, DE, AUG. 6 - 8, 2002; [PROCEEDINGS IEEE/CORNELL CONFERENCE ON HIGH PERFORMANCE DEVICES], NEW YORK, NY : IEEE, US, 6 août 2002 (2002-08-06), pages 402-408, XP010621976, DOI: 10.1109/LECHPD.2002.1146780 ISBN: 978-0-7803-7478-2

- MUJAGIÄ ELVIS ET AL: "Vertically emitting terahertz quantum cascade ring lasers", APPLIED PHYSICS LETTERS, AIP, AMERICAN INSTITUTE OF PHYSICS, MELVILLE, NY, US, vol. 95, no. 1, 10 juillet 2009 (2009-07-10), pages 11120-11120, XP012121928, ISSN: 0003-6951, DOI: 10.1063/1.3176966

## Description

La présente invention concerne un dispositif laser d'émission d'onde dans une gamme de fréquences comprises entre 0,5 THz et 5 THz.

Le domaine Térahertz (THz) du spectre électromagnétique est compris entre les micro-ondes et l'infrarouge lointain et s'étale de 500 GHz (0,5 THz) à 5 THz (typiquement 1 THz correspond à une énergie de 4 meV ou encore à une longueur d'onde dans le vide de 300 $\mu$m).

Les sources THz trouvent leurs principales applications dans la spectroscopie et l'imagerie dans les domaines de la sécurité et de la médecine. Elles peuvent par ailleurs être employées pour les télécommunications en espace libre à courte distance (par exemple à l'intérieur des immeubles) pour l'analyse non destructive d'aliments, de couches de finition, de circuits intégrés. Les technologies THz sont décrites de façon générale dans les documents « Cutting-edge terahertz technology » (M. Tonouchi, Nature Photonics, février 2007, p. 97) et « Terahertz technology : a land to be discovered » (M. Koch, Optics and Photonics News, mars 2007, p. 21).

Dans le contexte de la spectroscopie THz, on distingue en général la spectroscopie à large bande dans le domaine temporel (THz-TDS ou « THz Time Domain Spectroscopy ») et la spectroscopie utilisant une source THz monochromatique (CW ou «Continuous Wave »). De par leur résolution fréquentielle intrinsèquement limitée, les systèmes TDS sont surtout employés pour la spectroscopie de structures à faible facteur de qualité. En effet, dans une expérience de TDS typique, la fenêtre de temps est de 100 ps, d'où une résolution fréquentielle de 5 GHz. D'un autre côté, les sources THz continues et monochromatiques CW ont trouvé un vaste champ d'applications en spectroscopie astronomique ou dans l'étude des réactions chimiques se déroulant dans la haute atmosphère, où les résonances THz mises en jeu ont souvent des facteurs de qualité entre $10^2$ et $10^6$.

La spectroscopie THz présente par ailleurs d'importantes applications en sécurité civile et militaire, par exemple dans la détection d'agents chimiques ou d'explosifs. Dans toutes les situations où le produit analysé se trouve en phase gazeuse, les spectres acquis par une méthode CW ont une résolution bien supérieure à celle des spectres obtenus par une méthode TDS. La technologie TDS est quant à elle très largement utilisée pour la caractérisation de matériaux en phase condensée.

Concernant les sources TDS, les sources traditionnelles de rayonnement THz, comme les lasers à gaz ou les oscillateurs « backward wave oscillators », sont chères et encombrantes. Les sources THz reposant sur des ensembles d'oscillateurs solides sont aussi onéreuses. Aujourd'hui, les dispositifs les plus utilisés pour générer et détecter des impulsions THz large bande sont les antennes dipolaires photoconductrices excitées par un laser femtoseconde, qui est souvent coûteux et volumineux. De tels dispositifs sont décrits dans le document "Sensing with Terahertz Radiation" (D. Mittleman Springer-Verlag, Heidelberg (2003)).

On connaît par ailleurs différentes sources de type CW.

Une première source connue de type monochromatique CW utilise la technique de photomélange ou « Photomixing » : l'hétérodynage optique permet de générer une onde THz continue. Le battement de deux diodes laser continues émettant autour de 800 nm et désaccordées de quelques THz induit une oscillation de charge dans la bande de conduction d'un semi-conducteur tel que GaAs ou InGaAs semi-isolants.

Toutefois, les démonstrateurs réalisés à ce jour sont des systèmes non intégrés et les puissances THz maximales générées restent relativement faibles, de l'ordre de 100 nW, comme le montrent les documents "Photomixing up to 3,8 THz in low-temperature-grown GaAs" (E. R. Brown et al., Appl. Phys. Lett. 66, 285, (1995)) et "Generation and detection of coherent terahertz waves using two photomixers" (S. Verghese et al., Appl. Phys. Lett. 73, 3824 (1998)).

Les lasers à cascade quantique constituent un second type de sources monochromatiques CW dans le domaine THz. De telles sources sont décrites dans le document "Terahertz semiconductor-heterostructure laser", R. Kohler et al., Nature 417, 156 (2002). Ces sources permettent de générer une puissance plus élevée, mais elles sont peu accordables et ne fonctionnent qu'aux températures cryogéniques. Pour cette dernière raison, ces sources sont des systèmes encombrants et complexes.

Une troisième source connue de type CW utilise la technique de conversion de fréquence. Les effets non linéaires du second ordre sont ainsi utilisés pour la génération et l'amplification de THz, en suivant différentes approches :

- mélange de lasers moyen infrarouge dans du GaAs massif tel que décrit dans le document "Noncolinear phase matching in GaAs" (L. Aggarwal et al., Appl. Phys. Lett. 22, 239, (1973)) ;
- mélange d'impulsions ultra brèves proche-infrarouges dans des cristaux tels que ZnSe, LiNbO$_3$ tel que décrit dans le document "Generation of Far-Infrared Radiation by Picosecond Light Pulses in LiNbO3" (K. H. Yang et al., Appl. Phys. Lett. 19, 320, (1971)), ou LiNbO$_3$ retourné périodiquement (PPLN ou « Periodically Poled Lithium Niobate ») tel que décrit dans le document « Generation of narrow-band terahertz radiation via optical rectification of femtosecond pulses in periodically poled lithium niobate » (Y.-S. Lee et al.,Appl. Phys. Lett. 76, 2505 (2000)).

De par son fort coefficient non linéaire et ses faibles pertes dans le domaine THz (~1 cm$^{-1}$), le GaAs constitue un matériau de choix pour ces applications. Le document "Terahertz-wave generation in quasi-phase-matched GaAs" (K. L. Vodopyanov et al., Appl. Phys. Lett. 89, 141119, (2006)) décrit la génération d'ondes THz de 0,9 à 3 THz dans du GaAs périodiquement inversé, avec une efficacité de conversion de $10^{-3}$ en utilisant deux faisceaux de pompe au voisinage de 3 $\mu$m.

Toutefois, tous ces systèmes ne sont ni compacts, ni aisés à mettre en oeuvre hors d'un laboratoire de recherche.

Le document "Nonlinear phase matching in THz semiconductor waveguides" (V. Berger and C. Sirtori, Semicond. Sci. Technol. 19, 964 (2004)) propose d'exploiter la dispersion anormale créée par l'absorption par la bande de phonon dans GaAs pour accorder en phase deux faisceaux de pompe proche IR (Infrarouge) et le faisceau THz généré dans un guide d'onde de type « ridge »; cette proposition n'a pas encore fait l'objet d'une démonstration expérimentale. Par ailleurs, tout comme les autres solutions, elle ne permet pas d'obtenir un système compact.

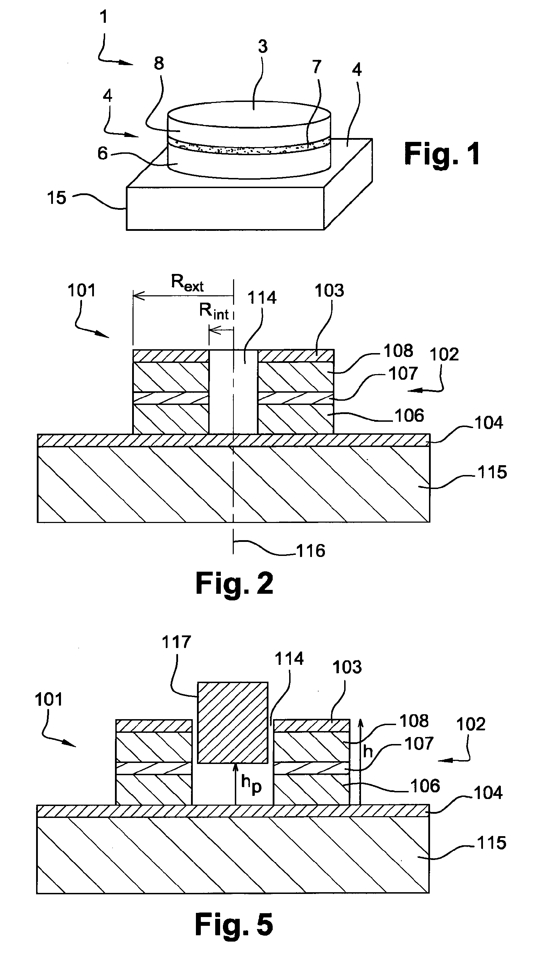

Une solution à cette problématique de compacité est proposée dans le brevet FR2932616 qui décrit un dispositif laser compact d'émission d'onde lumineuse dans une gamme de fréquence comprise entre 0,5 THz et 5 THz permettant de s'affranchir des limitations mentionnées ci-dessus en termes d'encombrement, de complexité et de coût. La figure 1 représente un exemple d'un tel dispositif 1.

Le dispositif 1 est une source continue ou quasi continue de radiations électromagnétiques THz. La génération du rayonnement THz est assurée par conversion paramétrique (i.e. différence de fréquences) à partir de deux modes optiques d'un microlaser semiconducteur à modes de galerie.

Le dispositif 1 comporte ainsi une hétérostructure semiconductrice 2 cylindrique dont les extrémités sont chacune couvertes d'une couche métallique formant respectivement un miroir supérieur 3 et un miroir inférieur 4. Cette hétérostructure semiconductrice 2 repose sur un substrat hôte 15.

L'hétérostructure 2 comporte une couche active centrale 7 qui se comporte comme un guide d'onde dans le proche infrarouge, entourée de deux couches dopées 6 et 8 de plus grande bande interdite et de plus faible indice, qui assurent le confinement optique des modes laser et le transport du courant vers la couche active. Du fait de sa géométrie cylindrique, cette hétérostructure 2 supporte des modes électromagnétiques de haut facteur de qualité qui « tournent en rond » dans l'hétérostructure 2 du fait de la réflexion totale interne de la lumière à la périphérie du cylindre.

La couche active 7 contient un milieu amplificateur, constitué par exemple par un ensemble de boîtes quantiques. Du fait de leur distribution de taille, le gain procuré par les boîtes quantiques présente un fort élargissement inhomogène. Le milieu émetteur fournit le gain nécessaire pour faire laser simultanément plusieurs modes optiques de galerie dans le proche infrarouge.

Le matériau utilisé pour la couche active centrale 7 est par exemple un alliage d'arséniure de gallium et d'aluminium (GaAlAs) qui est un matériau semiconducteur optiquement non linéaire dont certains coefficients non linéaires du second ordre sont élevés. Si les conditions nécessaires à la génération paramétrique par différence de fréquences sont remplies, on prévoit théoriquement une génération efficace de rayonnement Térahertz, et des puissances émises supérieures à 0.1 $\mu$W en continu. Notons que pour obtenir ce résultat, deux couches métalliques 3 et 4, par exemple en or, doivent être placées en haut et en bas du microcylindre 2 pour confiner l'onde Térahertz et maximiser son recouvrement avec la couche active. Du fait du diamètre suffisamment grand du cylindre (quelques dizaines de microns), il existe aussi des modes de galerie dans le domaine Térahertz.

Le dispositif décrit ci-dessus présente toutefois certaines difficultés.

En effet, pour que la génération Térahertz par différence de fréquences soit efficace, il faut qu'il existe pour cette structure deux modes de galeries proche-infrarouges M1 et M2 et un mode de galerie Térahertz M3 qui satisfassent les deux conditions nécessaires suivantes :

1) la conservation de l'énergie dans le processus élémentaire de génération paramétrique : $\nu 1 - \nu 2 = \nu 3$ (*) où $\nu i$ désigne la fréquence du mode de galerie i ;

2) la condition d'accord de phase qui s'écrit, pour des modes de galerie : $m1 - m2 \pm 2 = m3$ (**) où $mi$ désigne le nombre quantique azimutal associé au mode de galerie i.

Pour mémoire, un mode de galerie est caractérisé par sa polarisation - transverse électrique TE ou transverse magnétique TM - et par trois nombres entiers, qui caractérisent son ordre vertical (correspondant à l'ordre du mode suivant la direction verticale du cylindre), radial (correspondant à l'ordre du mode suivant le rayon du cylindre) et azimutal (nombre quantique azimutal).

En pratique, même s'il existe certains modes permettant de satisfaire à la fois les conditions (*) et (**), il demeure difficile de satisfaire simultanément ces deux conditions.

De plus, la fréquence des modes de galerie présente une dépendance rapide en fonction du diamètre du cylindre, qui ne doit pas dévier de plus de 20 nm de sa valeur nominale pour que les conditions (*) et (**) restent simultanément satisfaites. Sachant que le diamètre typique d'une telle hétérostructure cylindrique est de l'ordre de 40 $\mu$m, la précision requise est à la limite des possibilités technologiques actuelles.

Enfin, une rectification *a posteriori* du diamètre de l'hétérostructure cylindrique est difficilement envisageable sans dégrader la qualité de ses surfaces latérales (augmentation de la rugosité), et par là même le facteur de qualité des modes de galerie M1 et M2 et la puissance maximale pouvant être émise par la source.

Dans ce contexte, la présente invention a pour but de fournir un dispositif laser compact d'émission d'onde lumineuse dans une gamme de fréquence comprise entre 0,5 THz et 5 THz permettant de s'affranchir des limitations en termes d'encombrement, de complexité et de coût tout en facilitant la réalisation simultanée des conditions de conservation d'énergie (\*) et d'accord de phase (\*\*).

A cette fin, l'invention propose un dispositif laser d'émission d'onde dans une gamme de fréquence comprise entre 0,5 THz et 5 THz comportant une hétérostructure semiconductrice de forme sensiblement cylindrique à section circulaire, ladite hétérostructure comportant :

- une première couche en matériau semiconducteur optiquement non linéaire incluant des moyens émetteurs aptes à émettre dans au moins deux modes de galerie optiques appartenant au proche infrarouge, lesdits au moins deux modes de galerie étant confinés dans ladite première couche et permettant la génération au sein de ladite première couche d'un rayonnement dans un mode de galerie électromagnétique de fréquence comprise entre 0,5 THz et 5 THz, dit mode Térahertz, ledit rayonnement étant généré par différence des fréquences desdits deux modes de galerie, la géométrie sensiblement cylindrique de ladite hétérostructure assurant l'accord de phase entre les deux modes de galerie optiques appartenant au proche infrarouge et le mode Térahertz à la fréquence différence;
- une deuxième et une troisième couche en matériau semiconducteur présentant chacun un indice optique plus faible que l'indice du matériau utilisé pour ladite première couche et situées de part et d'autre de ladite première couche ;
- au moins une couche métallique située à une extrémité de ladite hétérostructure ;

ledit dispositif étant **caractérisé en ce que** ladite hétérostructure est munie en son centre d'un trou de forme sensiblement cylindrique s'étendant sur toute la hauteur de ladite hétérostructure.

On entend par proche infrarouge un rayonnement de longueur d'onde comprise entre 0,7 $\mu$m et 1,4 $\mu$m.

On entend par mode de galerie optique un mode résultant de la réflexion de rayons lumineux sur la paroi cylindrique intérieure de la première couche formant microcavité réalisée dans un matériau dont l'indice de réfraction est plus élevé que le milieu qui l'entoure (i.e. l'air). Les rayons restent en général confinés le long de la paroi cylindrique et ne passent pas par le centre de la microcavité.

On entend par forme sensiblement cylindrique une forme cylindrique ou tronconique ; en effet, les variations de diamètre de la section de la structure et/ou du trou ne perturbent pas le fonctionnement du dispositif dans la mesure où elles restent faibles. On conçoit aisément que la fabrication, notamment par gravure, du dispositif peut conduire à des formes qui ne sont pas parfaitement cylindriques, notamment des formes tronconiques.

Le dispositif selon l'invention utilise avantageusement un trou cylindrique central dont le diamètre forme un nouveau paramètre, permettant de faciliter la réalisation simultanée des conditions (\*) et (\*\*), ou encore de corriger simplement, après fabrication et test, les dispositifs ne présentant pas des caractéristiques optimales.

Comme dans le cas du dispositif de la figure 1, l'onde THz est générée par différence de fréquence (i.e. conversion paramétrique) à partir de deux modes de galerie appartenant au proche infrarouge et présents dans ladite première couche centrale formant microcavité de type microcylindre : la réflexion sur l'interface semiconducteur-air du microcylindre conduit à la formation de modes de galerie THz. Les modes de galerie à très haut facteur de qualité sont excités par des émetteurs tels que des boîtes ou des puits quantiques. Les émetteurs sont préférentiellement pompés électriquement mais peuvent également être pompés optiquement.

Le dispositif permet l'émission continue ou quasi continue de radiations électromagnétiques THz.

Selon à l'invention, le trou cylindrique au centre de l'hétérostructure cylindrique permet de former un anneau semiconducteur. Cette nouvelle géométrie est particulièrement intéressante car une modification du rayon du trou modifie la fréquence du mode Térahertz M3, qui est délocalisé dans tout le volume du cylindre, alors que la modification de ce même rayon n'affecte pas la fréquence des modes proche-infrarouges M1 et M2, qui sont localisés à la périphérie de l'hétérostructure cylindrique.

Ainsi, et partant d'un triplet de modes vérifiant la condition (\*\*), on pourra utiliser le diamètre du trou comme variable d'ajustement pour satisfaire in fine la condition (\*). En d'autres termes, après caractérisation des modes de galerie proche-infrarouges présents dans la bande de gain des émetteurs, on choisit le doublet (m1, m2), et m3 tel que (\*\*) soit satisfaite (ou mi est le nombre quantique azimutal associé au mode de galerie i). On peut ensuite déduire la valeur du rayon intérieur du trou qui permet de satisfaire la condition de résonance (\*). Ce trou de rayon donné au centre de l'hétérostructure cylindrique peut être réalisé avec des outils de nanofabrication usuels tels des techniques de lithographie électronique ou de gravure ionique réactive.

La structure du dispositif selon l'invention permet donc d'élargir considérablement le choix de paramètres permettant de réaliser la source Térahertz.

Elle est aussi très utile pour concevoir des réseaux de microsources Térahertz présentant des fréquences voisines, pour des applications multispectrales.

Pour un choix (m1, m2, m3) donné, on peut en effet définir la fréquence Térahertz en jouant sur le diamètre extérieur du cylindre pour modifier ν1 - ν2, puis jouer sur la taille du trou pour satisfaire la condition (*).

En outre, l'existence du trou central selon l'invention permet de corriger la source Térahertz après l'avoir testée. En effet, on peut facilement modifier la taille ou la forme du trou pour ajuster la fréquence ν3, par exemple en enlevant ou rapportant de la matière à l'aide d'un instrument de gravure et de dépôt par faisceau d'ions focalisé (FIB). On notera qu'une dégradation éventuelle de la qualité de la surface du trou n'affecte ni le facteur de qualité des modes M1 et M2, qui sont localisés au voisinage de la surface extérieure du cylindre, ni celui du mode M3, qui est très faible.

Le dispositif selon l'invention possède en outre tous les avantages du dispositif de l'art antérieur tel que représenté en figure 1.

Ainsi, la géométrie cylindrique de l'invention avec des émetteurs à l'intérieur de la première couche cylindrique permet d'aboutir à la génération de hautes puissances THz au sein d'une source compacte. La symétrie cylindrique de la première couche centrale en matériau semiconducteur optiquement non linéaire tel que du GaAs favorise l'accord de phase entre les modes de galerie optiques et le mode THz.

La couche métallique située à une extrémité de l'hétérostructure cylindrique assure le confinement vertical du mode THz selon le principe des guides métalliques plasmoniques. Ce confinement permet d'augmenter l'efficacité du rendement de conversion non linéaire. La couche métallique permet également l'injection des porteurs de charge dans le cas d'un pompage électrique des émetteurs.

La géométrie selon l'invention permet par ailleurs d'optimiser simultanément et indépendamment le confinement vertical des modes de galerie optiques et celui du mode THz, en jouant sur les épaisseurs des différentes couches, en particulier les épaisseurs des deuxième et troisième couches en matériau semiconducteur tel que du AlGaAs. Ceci permet de maximiser le recouvrement entre les modes optiques et le mode THz. On notera que les deuxième et troisième couches permettent non seulement de régler l'espacement entre le miroir et la couche active comportant les émetteurs mais également de réaliser le confinement optique latéral du mode THz.

La géométrie selon l'invention offre en outre, de par sa forme cylindrique sans étranglement, une bonne évacuation de la chaleur vers le substrat, assurant la stabilité en puissance des propriétés du laser et permettant d'atteindre des puissances laser compatibles avec la génération non linéaire de THz.

Le dispositif selon l'invention pourra être employé pour toute application requérant ce type de source, sachant qu'on retrouve des systèmes basés sur des sources THz dans l'imagerie, la spectroscopie, les communications sans fil, les capteurs, la métrologie et la défense.

Le dispositif selon l'invention permet de dépasser l'état de l'art actuel sur la génération de fréquences supérieures à 1 THz, c'est à dire le photomélange de deux raies laser avec une différence de fréquences correspondant à la fréquence THz générée.

Le dispositif selon l'invention comporte un élément de réglage réalisé dans un matériau faiblement absorbant dans la gamme de fréquence comprise entre 0,5 THz et 5 THz, ledit élément de réglage étant de dimension inférieure à celle dudit trou et inséré dans ledit trou.

Le dispositif selon l'invention peut également présenter une ou plusieurs des caractéristiques ci-dessous, considérées individuellement ou selon toutes les combinaisons techniquement possibles :

- la différence entre le rayon du cylindre formant ladite hétérostructure et le rayon du trou est supérieure à

$$0,05 \times \frac{\lambda_{THz}}{n_{THz}}$$ où $\lambda_{THz}$ est la longueur d'onde d'émission dans la gamme de fréquence comprise entre 0,5 THz et 5 THz et $n_{THz}$ est l'indice effectif de propagation du mode Térahertz à la longueur d'onde $\lambda_{THz}$ ;

- ladite hétérostructure semiconductrice repose sur une embase apte à refroidir ladite hétérostructure ;
- ledit élément est une pointe de forme sensiblement cylindrique à section circulaire ;
- ladite pointe présente un diamètre supérieur ou égal à un tiers du diamètre dudit trou ;
- ladite pointe présente un diamètre inférieur ou égal à trois quarts du diamètre dudit trou ;
- le matériau dudit élément de réglage est un matériau métallique ou un matériau semi-conducteur semi-isolant tel qu'un matériau semi-conducteur non dopé ;
- le dispositif selon l'invention comporte des moyens pour déplacer ledit élément de réglage suivant la hauteur dudit trou de sorte que l'écart entre ledit élément et le fond dudit trou est réglable.
- ledit dispositif selon l'invention comporte deux couches métalliques situées chacune à une extrémité de ladite hétérostructure ;
- ladite ou lesdites couches métalliques sont réalisées en or ;
- lesdits moyens émetteurs sont choisis parmi les boites quantiques, les structures à cascade quantique et les puits quantiques ayant avantageusement des épaisseurs différentes ;
- ledit matériau semiconducteur optiquement non linéaire de ladite première couche est un matériau III-V tel que le $Al_yGa_{1-y}As$ avec $0 \leq y \leq 0,6$ ou InGaAsP ou un matériau II-VI ;
- le matériau semiconducteur desdites deuxième et troisième couche est un matériau de la même famille que le matériau de la première couche et de bande interdite plus grande que celle du matériau de la première couche ; par exemple :

- pour $Al_yGa_{1-y}As$ dans la première couche, on peut choisir le matériau $Al_xGa_{1-x}As$ avec $0,2 \leq x \leq 0,9$ et $x > y$ ;
- pour InGaAsP dans la première couche, on peut choisir l'InP ;
- pour un matériau II-VI dans la première couche, on peut choisir un autre matériau II-VI ;
- ladite deuxième couche semiconductrice est une couche dopée p et ladite troisième couche semiconductrice est une couche dopée n ;
- ladite première couche inclut une pluralité de plans d'émetteurs ;
- l'épaisseur desdites deuxième et troisième couche est comprise entre 0,5 et 5 $\mu m$ ;
- le dispositif selon l'invention comporte deux contacts électriques pour l'injection d'un courant de pompage desdits moyens émetteurs ;
- l'épaisseur de ladite première couche est comprise entre 200 et 700 nm ;
- le diamètre de ladite hétérostructure cylindrique est compris entre 30 et 100 $\mu m$ ;
- ladite première couche est une couche non intentionnellement dopée.

La présente invention a également pour objet un procédé d'ajustement de la fréquence du mode Térahertz dans un dispositif selon l'invention **caractérisé en ce qu'il** comporte une étape consistant à régler la hauteur d'insertion de l'élément de réglage dans le trou de façon à obtenir la fréquence Térahertz recherchée.

Ainsi, on peut aussi approcher du trou, ou y insérer, ou déplacer à l'intérieur du trou, un élément de réglage non absorbant dans le Térahertz (par exemple une pointe métallique ou semiconductrice) afin de modifier la fréquence du mode de galerie Térahertz. On peut de plus envisager de réaliser cette opération d'ajustement et d'optimisation des propriétés de la source Térahertz, alors qu'elle est en fonctionnement, pour optimiser la satisfaction de la condition (*), et donc la puissance émise par la source. Cette optimisation in operando permet notamment de compenser l'effet d'un changement de température, qu'il soit dû à une variation de la température ambiante, ou à une variation de la température interne du composant due à un changement des conditions de fonctionnement (ex : courant injecté). On utilisera alors par exemple un système d'actuation, permettant d'optimiser en continu la puissance Térahertz générée à la fréquence v3 en jouant sur la position de l'objet mobile inséré dans le trou, en fonction de la puissance Térahertz mesurée par un détecteur de contrôle.

La présente invention a également pour objet un procédé d'ajustement de la fréquence du mode Térahertz dans un dispositif selon l'invention **caractérisé en ce qu'il** comporte une étape consistant à modifier la taille du trou de façon à obtenir la fréquence Térahertz recherchée.

Avantageusement, ladite étape consistant à modifier la taille du trou est une étape de retrait ou d'ajout de matière.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 illustre un exemple de réalisation d'un dispositif laser selon l'état de la technique ;
- les figures 2 et 3 illustrent un exemple de réalisation d'un dispositif laser selon l'invention ;
- la figure 4 représente la variation de la fréquence du mode Térahertz et de la différence de fréquences des modes proche-infrarouges en fonction du rayon intérieur du dispositif selon l'invention ;
- la figure 5 représente le dispositif de la figure 2 muni d'un élément de réglage ;
- les figures 6 à 8 illustrent l'évolution du décalage en fréquence du mode Térahertz en fonction de différents paramètres ;
- les figures 9a à 9f illustrent les différentes étapes d'un procédé de fabrication d'un dispositif tel que représenté aux figures 2 et 3.

Dans toutes les figures qui suivent, les éléments communs portent les mêmes numéros de référence.

La figure 2 représente un mode de réalisation d'un dispositif laser 101 selon l'invention.

Le dispositif 101 selon l'invention est une source continue ou quasi continue de radiations électromagnétiques THz. La génération du rayonnement THz est assurée par conversion paramétrique (i.e. différence de fréquences) à partir de deux modes optiques d'un microlaser semiconducteur à modes de galerie.

Le dispositif 101 comporte ainsi une hétérostructure semiconductrice 102 cylindrique de section circulaire dont les extrémités sont chacune couvertes d'une couche métallique (par exemple en or) formant respectivement un miroir supérieur 103 et un miroir inférieur 104. Le diamètre de l'hétérostructure cylindrique 2 est typiquement compris entre 30 et 100 $\mu m$.

L'hétérostructure repose sur un substrat 115.

Cette hétérostructure semiconductrice est munie d'un trou 114 en son centre ; le trou 114 est de forme cylindrique, le cylindre formant ledit trou étant à section circulaire et s'étendant sur toute la hauteur h de l'hétérostructure 102. En d'autres termes, les cylindres formant respectivement l'hétérostructure 102 et le trou 114 sont concentriques, le rayon $R_{int}$ du cylindre formant le trou 114 étant inférieur au rayon $R_{ext}$ du cylindre externe formant l'hétérostructure 102. Par souci de clarté les rayons $R_{int}$ et $R_{ext}$ ne sont pas à l'échelle. Le dispositif 101 a un axe de symétrie cylindrique représenté par la ligne pointillée 116.

L'hétérostructure semiconductrice 102 repose sur un substrat hôte 115 bon conducteur de la chaleur et de l'électricité, par exemple un substrat métallique ou un substrat GaAs dopé et recouvert d'une couche métallique 104 formant le miroir inférieur.

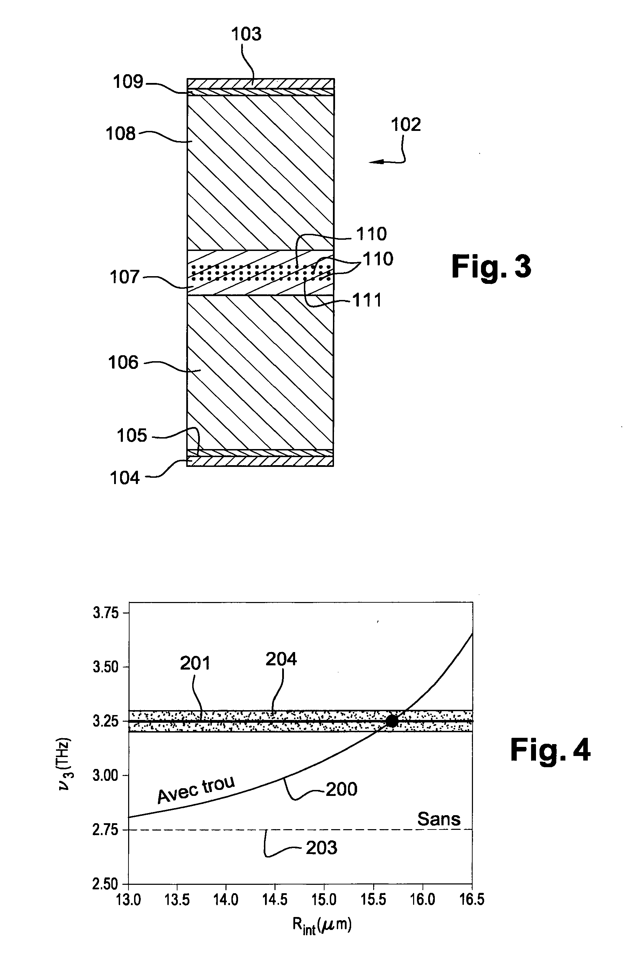

L'hétérostructure cylindrique 102 comporte une pluralité de couches ayant chacune la forme d'un anneau de rayon Rint ; cette pluralité de couches est illustrée en figure 3. On notera que le miroir inférieur 104 est représenté en figure 3 mais n'est pas ici de forme annulaire ; en d'autres termes, il ne fait pas partie intégrante de la géométrie cylindrique munie du trou 115. Ainsi l'hétérostructure 102 cylindrique comporte de bas en haut :

- une fine couche 105 (quelques nm, typiquement entre 2 et 30 nm) de GaAs dopée p;

- une couche 106 d'alliage $Al_xGa_{1-x}As$ dopée p (avec typiquement $0,2 \leq x \leq 0,9$) dont l'indice optique est plus faible que celui du matériau de la couche active et dont l'épaisseur est par exemple comprise entre 0,5 et 5 $\mu$m et préférentiellement comprise entre 0,5 et 3 $\mu$m;

- une couche active 107 ;

- une couche 108 d'alliage $Al_xGa_{1-x}As$ dopée n (avec typiquement $0,2 \leq x \leq 0,9$) dont l'indice optique est plus faible que celui du matériau de la couche active et dont l'épaisseur est par exemple comprise entre 0,5 et 5 $\mu$m et préférentiellement comprise entre 0,5 et 3 $\mu$m;

- une fine couche 109 (quelques nm, typiquement entre 2 et 30 nm) de GaAs dopée n ;

- le miroir supérieur 103.

La couche active 107 est une couche de GaAs ou d'$Al_xGa_{1-x}As$ non intentionnellement dopée ayant une épaisseur typiquement comprise entre 200 et 700 nm. La couche 107 d'$Al_xGa_{1-x}As$ contient de plus un milieu émetteur, ici une pluralité de plans 110 de boîtes quantiques 111 : un seul plan de boites quantiques peut être suffisant et on peut également utiliser un ou plusieurs puits quantiques. Le milieu émetteur est ici pompé électriquement. Deux contacts électriques non représentés sont prévus à cet effet. Les boites quantiques 111 procurent le gain nécessaire pour assurer l'effet laser.

Le milieu émetteur pompé électriquement suppose bien entendu un dopage adéquat de l'hétérostructure semiconductrice 102. Ainsi, comme décrit plus haut, la couche 106 d'$Al_xGa_{1-x}As$ inférieure et la fine couche 105 de GaAs en contact avec le miroir inférieur 104 sont dopées p tandis que la couche 108 d'$Al_xGa_{1-x}As$ supérieure et la fine couche 109 de GaAs en contact avec le miroir supérieur 3 sont dopées n.

On notera que les fines couches 105 et 109 ne sont représentés qu'en figure 3 par souci de simplification de la figure 2.

Le confinement des deux modes de galerie proche infrarouge est assuré par la couche active 107. La géométrie cylindrique de la couche active 107 assure un confinement vertical de la lumière proche infrarouge et la réflexion sur l'interface semiconducteur-air de cette couche microcylindrique 107 donne naissance à des modes de galerie proche-infrarouges.

Le confinement vertical du mode THz est assuré par les deux miroirs supérieur et inférieur 103 et 104. Ces deux miroirs métalliques 103 et 104 forment un guide pour les ondes électromagnétiques THz et assurent un confinement vertical record du mode THz, selon le principe des guides métalliques plasmoniques pour les ondes THz. Ce confinement permet d'augmenter l'efficacité du rendement de conversion non linéaire dans le cadre du dispositif 101 selon l'invention. On notera que le principe de guide métallique plasmonique peut également s'appliquer avec un seul miroir (dans ce cas, le confinement vertical du mode THz est également de type plasmonique mais avec un seul miroir autorisant une excitation optique des émetteurs, la présence d'un seul miroir entraînant cependant une perte en confinement du mode THz). La réflexion sur l'interface semiconducteur-air du microcylindre conduit à la formation de modes de galerie THz. Les couches 106 et 108 d'$Al_xGa_{1-x}As$ permettent d'éloigner le mode guidé des miroirs métalliques 103 et 104 et de limiter les pertes optiques par absorption dans le métal. Les modes optiques infrarouges confinés dans la couche active centrale 107 ont en effet tendance à « baver » dans les couches 106 et 108. Dès lors, si les miroirs métalliques sont trop près de la couche centrale, les modes optiques infrarouges sont susceptibles d'être absorbés par le métal. L'épaisseur des couches 106 et 108 d'$Al_xGa_{1-x}As$ est donc choisie de manière à minimiser les pertes des modes optiques infrarouges.

Selon l'invention, la même hétérostructure semiconductrice 102 assure les fonctions de source laser de pompe et de conversion de fréquence. Cette approche permet potentiellement d'éliminer tous les problèmes d'alignement optique et simplifie énormément l'assemblage du dispositif 101 selon l'invention. Elle aboutit à un dispositif 101 émetteur de radiation THz extrêmement compact.

On notera qu'il est également possible d'inverser les couches dopées p et n (i.e. faire passer les couches ayant un dopage n au niveau supérieur et les couches ayant un dopage p au niveau inférieur) sans sortir du cadre de l'invention : les prises de contact électrique devront bien entendu être adaptées au type de dopage.

A titre purement illustratif, on trouvera ci-dessous un exemple de dimensionnement du dispositif 101 selon l'invention :

- épaisseur de la couche guide active 107 d'$Al_{0,34}Ga_{0,66}As$: 500 nm ;

- composition et épaisseur des couches espaceurs 106 et 108 de confinement optique : $Al_{0,8}Ga_{0,2}As$, 2 $\mu$m ;

- épaisseur des fines couches de GaAs dopées p et n 105 et 109 : 20nm ;

- rayon $R_{ext}$ de l'hétérostructure cylindrique 102: 17,48 $\mu$m ;
- rayon Rint du trou cylindrique 114 : 15,72 $\mu$m

Dans l'exemple illustré ci-dessus, le calcul des modes de galerie de la structure montre que les conditions de conservation d'énergie (*) et d'accord de phase (**) sont obtenues entre les modes proche-infrarouges et le mode Térahertz dont les fréquences et les nombres quantiques (ou ordres) azimutaux sont les suivants à une température de fonctionnement de 300K :

- m1=253 et $\nu$1 = 230.50 THz ($\lambda$1= 1.3006 $\mu$m) pour le premier mode proche IR M1 ;
- m2=249 et $\nu$2 = 227.23 THz ($\lambda$2= 1.3194 $\mu$m) pour le second mode proche IR M2 ;
- m3=2 et $\nu$3 = 3.27 THz ($\lambda$3= 91.79 $\mu$m) pour le mode Térahertz M3.

La longueur d'onde d'émission des boîtes quantiques est ici choisie au voisinage de 1.31 $\mu$m. La largeur spectrale de la bande d'émission des boîtes quantiques est de l'ordre de 40 meV, ce qui permet d'obtenir l'effet laser pour les modes proche-infrarouges M1 et M2.

Comme déjà mentionné plus haut, on entend par proche infrarouge un rayonnement de longueur d'onde comprise entre 0,7 $\mu$m et 1,4 $\mu$m et par mode de galerie optique un mode résultant de la réflexion de rayons lumineux sur la paroi intérieure de la couche 107 formant microcavité cylindrique.

On notera que, pour le jeu de paramètres mentionnés ci-dessus, il n'y a pas, en l'absence de trou 114, de mode Térahertz permettant de satisfaire simultanément les deux conditions de conservation de l'énergie (*) et d'accord de phase (**).

La figure 4 présente la variation (courbe 200) de la fréquence THz $\nu$3 du mode de galerie d'indice m3 (ici m3=2) en fonction du rayon $R_{int}$ du trou central, tous les autres paramètres étant conservés constants. On notera que la fréquence du mode THz d'indice m3=2 croît continûment en fonction du rayon interne $R_{int}$. La relation (*) de conservation de l'énergie est satisfaite pour un rayon interne $R_{int}$ de 15,72 $\mu$m correspondant à la valeur du rayon décrite plus haut en référence aux figures 2 et 3. Cette valeur est obtenue en prenant l'intersection de la courbe 200 et de la courbe 201 illustrant la différence de fréquence des modes proche-infrarouges d'ordre m1 (ici m1=253) et m2 (ici m2=249). La courbe 201 est une courbe constante en fonction du rayon (i.e. la différence de fréquence des modes proche-infrarouges d'ordre m1=253 et m2=249 est égale à 3,27 THz quel que soit le rayon $R_{int}$). La zone 204 schématise la largeur spectrale du mode THz (facteur de qualité typique Q~40).

Sans trou 114, la fréquence $\nu$3 est constante et égale à 2,75 THz (ligne pointillée 203) et on ne peut donc satisfaire la condition de conservation de l'énergie.

On constate sur la figure 4 que la précision requise (déterminée via la largeur spectrale 204) sur le rayon intérieur $R_{int}$ du trou 104 pour obtenir la condition de conservation de l'énergie (*) est de l'ordre de 0,2 $\mu$m. La précision requise est donc beaucoup moins exigeante pour que pour un dispositif tel que le dispositif 1 de la figure 1. Rappelons que pour un cylindre plein tel que représenté en figure 1, la précision requise sur le diamètre du cylindre est dix fois plus petite (0,02 $\mu$m).

La figure 4 illustre un deuxième intérêt de la géométrie en anneau (i.e. cylindre troué) : la variation relativement lente de la fréquence $\nu$3 du mode THz m3 en fonction du rayon intérieur $R_{int}$ permet de réaliser plus facilement une structure satisfaisant les conditions (*) et (**).

Selon une première approche, on peut commencer par fabriquer un microcylindre ; après caractérisation des modes de galerie proche-infrarouges présents dans la bande de gain des boîtes quantiques, on choisit le doublet (m1, m2), et m3 tel que la condition d'accord de phase (**) soit satisfaite. On peut ensuite déduire, comme dans la figure 4, la valeur du rayon du trou 104 $R_{int}$ qui permet de satisfaire la condition de conservation d'énergie, dite également condition de résonance, (*). Il est aisé pour l'homme du métier de réaliser ensuite un trou de rayon $R_{int}$ au centre du cylindre avec les outils de nanofabrication connus, par exemple la lithographie électronique et la gravure ionique réactive.

Selon une seconde approche, on peut directement fabriquer une structure de type annulaire, puis corriger le rayon intérieur de celle-ci (i.e. le rayon $R_{int}$) après caractérisation et mesure des fréquences des modes de galerie, en utilisant par exemple une gravure par faisceau d'ions focalisés. Si on adopte cette seconde approche, on choisira préférentiellement un rayon initial $R_{int}$ légèrement trop petit pour l'anneau, de façon à pouvoir ensuite l'ajuster à sa valeur optimale lors de l'étape de gravure par faisceau d'ions.

Les approches qui viennent d'être décrites permettent de fabriquer une microsource de rayonnement THz pour laquelle la condition de résonance (*) est satisfaite au voisinage d'une température donnée, par exemple la température ambiante (T proche de 300K).

Toutefois, en cours de fonctionnement, la température interne du composant s'élève, du fait de la dissipation thermique par effet Joule. Lorsqu'on augmente le courant injecté dans la microsource, l'indice de réfraction des matériaux semi-conducteurs formant l'hétérostructure, et donc la fréquence de galerie, sont modifiés. Le système va donc progressivement s'écarter de la condition de résonance (*), nécessaire à une génération paramétrique efficace. A titre d'exemple une variation de 10°C modifie $\nu$1-$\nu$2-$\nu$3 de quelques GHz. Cet effet limite donc la puissance THz maximale susceptible d'être émise par la source.

De plus, le décalage spectral de la courbe de gain induit par l'élévation de température peut conduire à l'extinction de modes laser proche-infrarouges, et à l'apparition de l'effet laser pour de nouveaux modes. De telles modifications du spectre d'émission du microlaser écartent, elles aussi, le système de la condition de résonance (*).

De manière particulièrement avantageuse, il est donc souhaitable d'ajouter un moyen de contrôle supplémentaire, qui permette d'optimiser la satisfaction de la condition (*), et de corriger les déviations induites par l'élévation de température en cours de fonctionnement.

On peut par exemple intégrer le dispositif selon l'invention sur une embase refroidie, par exemple par effet Peltier. On pourra alors jouer sur la température de l'embase pour ajuster la température interne du composant, et optimiser la puissance THz émise, quel que soit le courant injecté dans le dispositif.

Selon un autre mode de réalisation de l'invention, qui peut être éventuellement combiné avec le contrôle de la température mentionné plus haut, on peut mettre en oeuvre une actuation mécanique au sein du dispositif selon l'invention.

La figure 5 illustre à titre d'exemple un dispositif 101 selon l'invention pour laquelle on a introduit une tige métallique 117 dans le trou central 114. La tige métallique 117 a ici la forme d'une pointe cylindrique de diamètre $1,8.R_{int}$ où $R_{int}$ désigne toujours le rayon du trou 114. Le matériau utilisé pour la réalisation de la pointe 117 est peu absorbant dans le domaine spectral THz.

A l'exception de cette tige insérée dans le trou 114, le dispositif 101 est identique à celui illustré en figure 2.

La position de cette tige 117 peut être définie très précisément, latéralement et/ou verticalement, par exemple à l'aide de positionneurs piézoélectriques non représentés. On peut ainsi faire varier la hauteur $h_p$ de la tige métallique 117 par rapport au fond du trou.

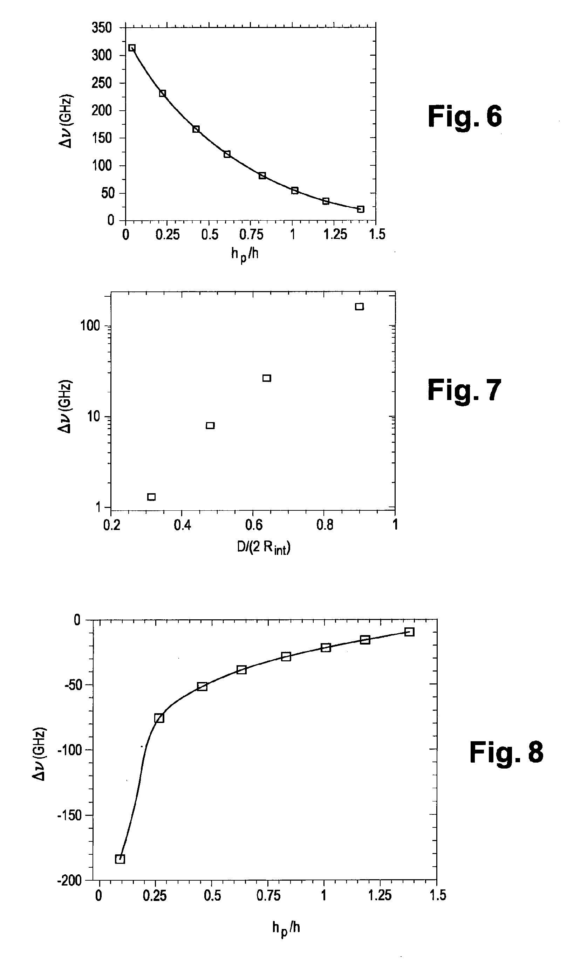

La figure 6 présente le décalage en fréquence du mode THz induit par la pointe métallique 117, en fonction de sa position verticale (plus précisément en fonction du ratio $h_p/h$ où h désigne la hauteur de l'hétérostructure 102). Pour la structure décrite en référence à la figure 2 et un diamètre de pointe de 28.2 $\mu$m, le déplacement de la pointe permet un ajustement fin de la fréquence du mode THz sur une plage de 0.3 THz environ. Il est important que le diamètre de la pointe soit comparable au diamètre intérieur de l'anneau, car la plage d'accordabilité spectrale est nettement plus étroite lorsqu'on réduit le diamètre de la pointe ; ce phénomène est notamment illustré sur la figure 7 qui représente le décalage en fréquence du mode THz en fonction du ratio $D/(2R_{int})$ pour une hauteur hp donnée (ici hp est égale à 0,5h), où D désigne le diamètre de la pointe 117 et $R_{int}$ désigne le rayon du trou 114. En pratique, on choisira une pointe de diamètre supérieur au tiers du diamètre du rayon intérieur.

De façon remarquable, en jouant sur la position de la pointe 117 de diamètre 1.8 $R_{int}$, on peut corriger l'effet d'une variation de température interne du dispositif de plus de 1000K, donc très largement supérieure aux variations susceptibles d'être observées en pratique. La condition de résonance (*) peut être maintenue, via une actuation de la position de la pointe, sur toute la plage de fonctionnement de la source. Cette actuation peut être réalisée en temps réel, de façon à maximiser à tout instant la puissance THz émise par la source.

La large plage d'accord accessible à l'aide de cette pointe peut aussi être employée, bien entendu, pour corriger un écart des dimensions de la source par rapport à ses paramètres nominaux.

On peut employer une pointe réalisée dans un matériau de nature différente, tant que le matériau employé est peu absorbant dans le domaine spectral THz. A titre d'exemple, on peut employer une pointe faite à partir d'un matériau semiconducteur tel que GaAs, InP ou GaN.

De façon préférentielle, on utilisera une pointe semiconductrice semi-isolante, par exemple à base de semiconducteur non dopé. Une telle pointe non conductrice ne risque pas en effet de court-circuiter la jonction de la source en cas de contact accidentel de la pointe avec le bord intérieur de l'anneau (i.e. la surface du trou 114).

La figure 8 présente le décalage spectral induit par l'introduction d'une pointe cylindrique en GaAs sur le mode THz (les dimensions du dispositif sont les mêmes que pour la figure 2, et le diamètre de la pointe est égal à 1.5 $R_{int}$) en fonction du ratio $h_p/h$ où h désigne la hauteur de l'hétérostructure. Contrairement à la pointe métallique, qui introduit un décalage vers les hautes fréquences, la pointe semiconductrice induit un décalage du mode THz vers les basses fréquences. Ici encore, la large plage d'accordabilité du mode THz permet d'optimiser la satisfaction de la condition de résonance (*) sur toute la plage de fonctionnement de la source, ou de corriger un écart de la source par rapport à ses paramètres nominaux de fabrication.

S'agissant des dimensions de la pointe 117, cette dernière doit avoir un diamètre suffisamment grand, préférentiellement supérieur ou égal au tiers du diamètre intérieur du trou 114. Par ailleurs, son diamètre est préférentiellement inférieur ou égal à ¾ du diamètre du trou 114 de sorte que le mode THz soit bien confiné entre les couches métalliques.

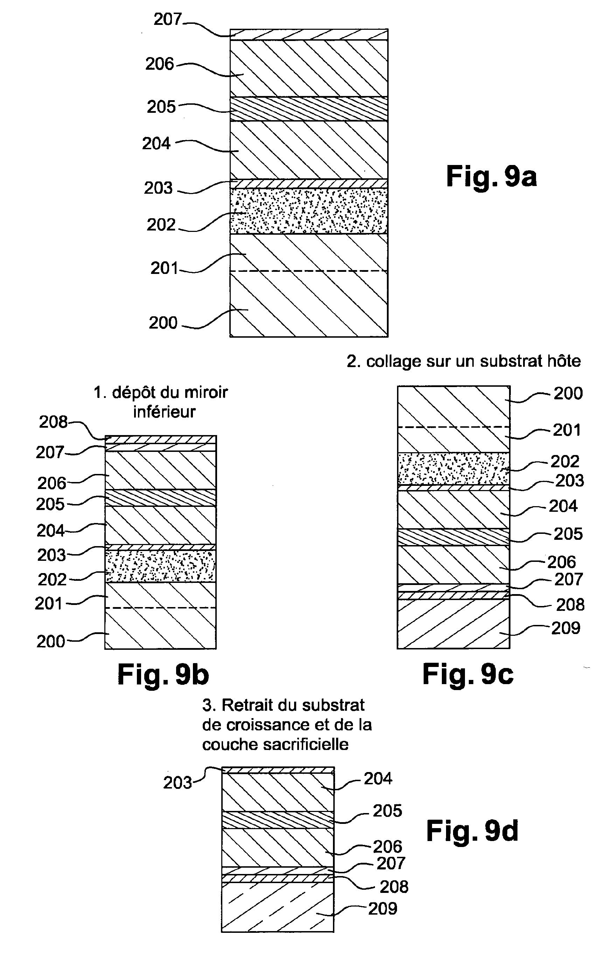

Les figures 9a à 9f illustrent les différentes étapes d'un exemple de procédé de réalisation du dispositif 101 selon l'invention.

La première étape représentée en figure 9a est constituée par une étape de croissance épitaxiale pour l'obtention des différentes couches de l'hétérostructure semiconductrice. L'hétérostructure semiconductrice est élaborée par une technique de croissance conventionnelle, telle que l'épitaxie par jets moléculaires (EJM) ou l'épitaxie en phase vapeur à partir de composés organométalliques (EPVOM).

Sur un substrat 200 en GaAs, on dépose une couche tampon 201 en GaAs, typiquement sur une épaisseur pouvant varier de 0,5 à 1 $\mu$m (servant à obtenir

une surface présentant une meilleure qualité que la surface du substrat 200), une couche sacrificielle 202 de GaAlAs de forte composition en Al (par exemple 500 nm de $Ga_{0.1}Al_{0.9}As$), puis les différentes couches semi-conductrices telles que représentées en figure 3 entre les deux miroirs métalliques, en suivant la séquence : GaAs-n (référence 203, par exemple sur une épaisseur de 20 nm) /$Al_xGa_{1-x}As$-n (référence 204, par exemple $Al_{0.8}Ga_{0.2}As$ dopé n sur une épaisseur de 2 $\mu$m) / $Al_xGa_{1-x}As$-nid (référence 205, par exemple $Al_{0.34}Ga_{0.66}As$ non intentionnellement dopé sur une épaisseur de 500 nm) / $Al_xGa_{1-x}As$-p (référence 206 par exemple $Al_{0.8}Ga_{0.2}As$ dopé p sur une épaisseur de 2 $\mu$m) /GaAs-p (référence 207).

Les fines couches de GaAs dopées p et n 207 et 203 de part et d'autre de la structure active servent à éviter une oxydation des couches de GaAlAs, potentiellement préjudiciable pour le bon fonctionnement du composant.

La croissance de la couche 205 $Al_xGa_{1-x}As$ non intentionnellement dopée est interrompue à une ou plusieurs reprises pour y insérer les émetteurs proche-infrarouges (puits quantiques ou plans de boîtes quantiques).

En référence à la figure 9b, on dépose un empilement 208 destiné à assurer un bon contact électrique avec la couche de confinement dopée de type p, et à former le miroir d'or inférieur. On pourra utiliser pour cela l'empilement 208 suivant : Ti (10 nm) Pt (40 nm) Au (250 nm).

En référence à la figure 9c, la structure épitaxiée obtenue suivant les étapes des figures 9a et 9b est ensuite retournée, reportée par collage sur un substrat hôte 209. Le report de cette structure sur le substrat hôte 209 peut être réalisé en utilisant une technique de collage usuelle (collage moléculaire, brasure, collage avec une colle époxy).

Le substrat hôte 209 est un substrat bon conducteur de la chaleur et de l'électricité, par exemple un substrat métallique ou un substrat de GaAs dopé.

Selon l'étape illustrée en figure 9d, le substrat 200 de GaAs initial est ensuite aminci par abrasion mécanique, jusqu'à une épaisseur de l'ordre de 50 $\mu$m. Le substrat restant est alors éliminé par une attaque chimique sélective, en utilisant la couche 202 sacrificielle d'Al-GaAs comme couche d'arrêt. On notera que la couche tampon 201 de GaAs est éliminée en même temps que le substrat 200. Finalement, la couche 202 sacrificielle d'AlGaAs est enlevée par une nouvelle attaque chimique sélective qui dégage la surface de la couche 203 de GaAs-n en vue des étapes technologiques ultérieures. Cette fine couche 203 de GaAs-n protège de l'oxydation la couche 204 d'$Al_xGa_{1-x}As$ dopée n sous-jacente.

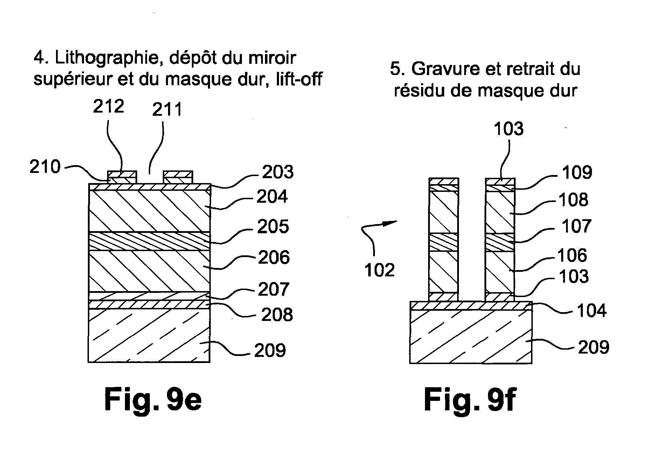

La figure 9e illustre l'étape de dépôt du miroir supérieur et de définition de la géométrie cylindrique trouée de l'hétérostructure. On réalise pour cela un niveau de lithographie permettant de définir par un procédé de type « lift-off » le miroir métallique annulaire supérieur 210 de diamètre égal au diamètre de l'hétérostructure de forme cylindrique et présentant en son centre un trou 211 de diamètre égal au diamètre du trou 114 de la figure 2.

Le miroir métallique supérieur 210 est ensuite soit utilisé directement comme masque de gravure soit recouvert d'une couche de contact 212 de type n (par exemple Ni (5 nm) Ge (10 nm) Au (20 nm) Ni (5 nm)). Les couches 210 et 212 sont éventuellement renforcées par le dépôt d'une couche métallique supplémentaire, par exemple 50 nm de nickel.

La géométrie cylindrique trouée est ensuite définie par gravure ionique réactive RIE par exemple en utilisant un mélange de gaz chlorés.

On retrouve sur la figure 9f l'hétérostructure semiconductrice 102 à géométrie cylindrique comportant de bas en haut :

- le miroir inférieur 104 ;

- la fine couche 105 de GaAs dopée p;

- la couche 106 d'alliage $Al_xGa_{1-x}As$ dopée p;

- la couche active 107 ;

- la couche 108 d'alliage $Al_xGa_{1-x}As$ dopée n;

- la fine couche 109 de GaAs dopée n ;

- le miroir supérieur 103.

Le procédé de fabrication décrit ci-dessus est adapté à la réalisation en parallèle de plusieurs dispositifs selon l'invention, autorisant la réalisation de matrices d'émetteurs THz, pour des applications de génération THz de haute puissance, ou des sources à sélection de fréquences, dites sources agiles en fréquence.

Bien entendu, le dispositif et le procédé selon l'invention ne sont pas limités aux modes de réalisation qui viennent d'être décrits à titre indicatif et nullement limitatif en référence aux figures 2 à 9f.

Notamment, l'hétérostructure semiconductrice à géométrie cylindrique pourrait par exemple être réalisée dans une autre famille de matériaux semiconducteurs III-V ou II-VI, par exemple la famille InP/In-GaAs/InAs, et utiliser au choix des boîtes quantiques ou des puits quantiques, comme expliqué précédemment. Cette famille a notamment pour intérêt le caractère faiblement recombinant de la surface de ces matériaux, par rapport à GaAs/GaAlAs. On s'attend donc à réduire fortement les pertes de porteurs de charge par recombinaison non-radiative sur les surfaces latérales gravées.

En ce qui concerne le matériau à gain, on peut remplacer dans certains cas avantageusement les plans de boîtes quantiques par un ou quelques puits quantiques. On pourra en particulier utiliser plusieurs puits quantiques de différentes épaisseurs, et structurer la courbe de gain de façon à ce qu'elle présente deux maxima au voisinage de ν1 et de ν2. Pour la structure décrite dans la figure 2, on pourrait alors obtenir l'effet laser pour M1 (d'indice m1) et M2 (d'indice m1+4), sans faire laser les modes de galerie intermédiaires d'indice m1 +1, m1 +2 et m1 +3.

On peut choisir d'autres métaux que l'or, ou un alliage métallique, pour la réalisation des miroirs de confinement vertical du rayonnement THz.

Dans le cas de la source cylindrique décrite dans le brevet FR2932616, il a été proposé de rendre isolante la partie centrale du cylindre, par exemple en utilisant une étape d'implantation ionique. Cette zone isolante permet d'injecter le courant électrique de façon sélective au bord du cylindre, et de pomper plus efficacement les modes de galerie M1 et M2. Cette approche permet potentiellement de réduire le courant de seuil nécessaire pour déclencher l'effet laser dans ces modes, de réduire l'échauffement de la source et d'augmenter la puissance maximale pouvant être émise par celle-ci. On pourra dans un autre mode d'application de l'invention combiner l'emploi de la géométrie cylindrique munie d'un trou et d'une zone isolante située du côté intérieur de l'anneau (i.e. du côté de la surface de l'hétérostructure définissant le trou), et permettant d'injecter préférentiellement le courant du côté du bord extérieur de l'anneau, où sont localisés les modes M1 et M2.

Afin de modifier et contrôler le diagramme de rayonnement de la source THz, on peut également structurer le plan métallique sous-jacent, ou rajouter des microstructures au-dessus de la source, pour bénéficier d'un effet d'antenne. Dans le cas où une pointe métallique est utilisée, on peut structurer la pointe elle-même pour réaliser cette antenne.

**Revendications**

1. Dispositif (101) laser d'émission d'onde dans une gamme de fréquence comprise entre 0,5 THz et 5 THz comportant une hétérostructure semiconductrice (102) de forme sensiblement cylindrique à section circulaire, ladite hétérostructure comportant :

   - une première couche (107) en matériau semiconducteur optiquement non linéaire incluant des moyens émetteurs (110, 111) aptes à émettre dans au moins deux modes de galerie optiques appartenant au proche infrarouge, lesdits au moins deux modes de galerie étant confinés dans ladite première couche (107) et permettant la génération au sein de ladite première couche (107) d'un rayonnement dans un mode de galerie électromagnétique de fréquence comprise entre 0,5 THz et 5 THz, dit mode Térahertz, ledit rayonnement étant généré par différence des fréquences desdits deux modes de galerie, la géométrie sensiblement cylindrique de ladite hétérostructure assurant l'accord de phase entre les deux modes de galerie optiques appartenant au proche infrarouge et le mode Térahertz à la fréquence différence;
   - une deuxième (108) et une troisième (106) couche en matériau semiconducteur présentant chacun un indice optique plus faible que l'indice du matériau utilisé pour ladite première couche (107) et situées de part et d'autre de ladite première couche (107);
   - au moins une couche métallique (103, 104) située à une extrémité de ladite hétérostructure (102) ;

ledit dispositif étant **caractérisé en ce que** :

   - ladite hétérostructure (102) est munie en son centre d'un trou (114) de forme sensiblement cylindrique s'étendant sur toute la hauteur (h) de ladite hétérostructure (102), le rayon dudit trou (114) étant choisi pour permettre d'établir l'accord de phase ;
   - la différence entre le rayon ($R_{ext}$) du cylindre formant ladite hétérostructure (102) et le rayon ($R_{int}$) du trou est supérieure à $0{,}05 \times \dfrac{\lambda_{THz}}{n_{THz}}$ où $\lambda_{THz}$ est la longueur d'onde d'émission dans la gamme de fréquence comprise entre 0,5 THz et 5 THz et $n_{THz}$ est l'indice effectif de propagation du mode Térahertz à la longueur d'onde $\lambda_{THz}$ ;
   - le dispositif comporte un élément de réglage (117) réalisé dans un matériau faiblement absorbant dans la gamme de fréquence comprise entre 0,5 THz et 5 THz, ledit élément de réglage (117) étant de dimension inférieure à celle dudit trou (114) et inséré dans ledit trou.

2. Dispositif (101) selon la revendication précédente **caractérisé en ce que** ladite hétérostructure (102) semiconductrice repose sur une embase apte à refroidir ladite hétérostructure.

3. Dispositif selon l'une des revendications précédentes **caractérisé en ce que** lesdits moyens émetteurs sont choisis parmi les boites quantiques, les structures à cascade quantique et les puits quantiques ayant avantageusement des épaisseurs différentes.

4. Dispositif (101) selon l'une des revendications précédentes **caractérisé en ce que** ledit élément (117) est une pointe de forme sensiblement cylindrique à section circulaire.

5. Dispositif selon la revendication précédente **caractérisé en ce que** ladite pointe présente un diamètre supérieur ou égal à un tiers du diamètre dudit trou.

6. Dispositif selon l'une des revendications 4 ou 5 **caractérisé en ce que** ladite pointe présente un diamètre inférieur ou égal à trois quarts du diamètre dudit trou.

7. Dispositif selon l'une des revendications précédentes **caractérisé en ce que** le matériau dudit élément de réglage est un matériau métallique ou un matériau semi-conducteur semi-isolant tel qu'un matériau semi-conducteur non dopé.

8. Dispositif selon l'une des revendications précédentes **caractérisé en ce qu'il** comporte des moyens pour déplacer ledit élément de réglage suivant la hauteur dudit trou de sorte que l'écart entre ledit élément et le fond dudit trou est réglable.

9. Procédé d'ajustement de la fréquence du mode Térahertz dans un dispositif selon la revendication 8 **caractérisé en ce qu'**il comporte une étape consistant à régler la hauteur d'insertion de l'élément de réglage dans le trou de façon à obtenir la fréquence Térahertz recherchée.

10. Procédé d'ajustement de la fréquence du mode Térahertz dans un dispositif selon l'une des revendications 1 à 8 **caractérisé en ce qu'**il comporte une étape consistant à modifier la taille du trou de façon à obtenir la fréquence Térahertz recherchée.

11. Procédé selon la revendication précédente **caractérisé en ce que** ladite étape consistant à modifier la taille du trou est une étape de retrait ou d'ajout de matière.

## Patentansprüche

1. Vorrichtung (101) zur Ausgabe von Laserwellen in einem zwischen 0,5 THz und 5 THz inbegriffenen Frequenzband, umfassend eine Halbleiter-Heterostruktur (102) in deutlich zylindrischer Form mit kreisförmigem Querschnitt, wobei die genannte Heterostruktur umfasst:

- eine erste Schicht (107) aus optisch nicht linearem Halbleitermaterial, das Sendermittel (110, 111) einschließt, die geeignet sind, in wenigstens zwei optischen Galeriemodi, die in den Bereich des Infrarots gehören, zu senden, wobei die genannten wenigstens zwei Galeriemodi in der genannten ersten Schicht (107) eingeschlossen sind und das Erzeugen einer Strahlung in einem elektromagnetischen Galeriemodus einer zwischen 0,5 THz und 5 THz inbegriffenen Frequenz, bezeichnet als Terahertz, innerhalb der genannten ersten Schicht (107) zu erlauben, wobei die genannte Strahlung per Differenz der Frequenzen der genannten zwei Galeriemodi generiert werden, wobei die deutlich zylindrische Geometrie der genannten Heterostruktur die Phasenabstimmung zwischen den zwei optischen Galeriemodi, die in den Bereich des Infrarots gehören, und dem Modus Terahertz mit der Differenz-Frequenz gewährleisten;
- eine zweite (108) und eine dritte (106) Schicht aus Halbleitermaterial, die jeweils einen geringeren optischen Index aufweist als den Index des für die genannte erste Schicht (107) verwendeten Materials und die sich auf jeder Seite der genannten ersten Schicht (107) befinden;
- wenigstens eine Metallschicht (103, 104), die sich an einem Ende der genannten Heterostruktur (102) befindet,

wobei die genannte Vorrichtung **dadurch gekennzeichnet ist, dass**:

- die genannte Heterostruktur (102) in ihrem Zentrum mit einem Loch (114) mit deutlich zylindrischer Form versehen ist, die sich über die gesamte Höhe (h) der genannten Heterostruktur (102) erstreckt, wobei der Radius des genannten Lochs (114) ausgewählt ist, um die Herstellung der Phasenabstimmung zu erlauben
- die Differenz zwischen dem Radius ($R_{ext}$) des Zylinders, der die genannte Heterostruktur (102) bildet, und dem Radius ($R_{int}$) des Lochs größer

ist als $0,05 \times \frac{\lambda_{THz}}{\eta_{THz}}$, wobei $\lambda_{THz}$ die Emissionswellenlänge in dem zwischen 0,5 THz und 5 THz inbegriffenen Frequenzband und $\eta_{THz}$ der effektive Verbreitungsindex des Modus Terahertz bei der Wellenlänge $\lambda_{THz}$ ist,
- die Vorrichtung ein Einstellelement (117) umfasst, das aus einem schwach absorbierenden Material in dem zwischen 0,5 THz und 5 THz inbegriffenen Frequenzband realisiert ist, wobei das genannte Einstellelement (117) geringere Abmessungen aufweist als das des genannten Lochs (114) und in das genannte Loch eingefügt ist.

2. Vorrichtung (101) gemäß dem voranstehenden Anspruch, **dadurch gekennzeichnet, dass** die genannte Halbleiter-Heterostruktur (102) auf einer Basis ruht, die geeignet ist, die genannte Heterostruktur zu kühlen.

3. Vorrichtung gemäß einem der voranstehenden Ansprüche, **dadurch gekennzeichnet, dass** die genannten Sendermittel aus Quantenpunkten, Quantenkaskaden und Quantentöpfe ausgewählt sind, wobei die Quantentöpfe vorteilhaft unterschiedliche Dicken haben.

4. Vorrichtung (101) gemäß einem der voranstehenden Ansprüche, **dadurch gekennzeichnet, dass** das genannte Element (117) eine Spitze mit einer deutlich zylindrischen Form mit kreisförmigem Querschnitt ist.

5. Vorrichtung gemäß dem voranstehenden Anspruch, **dadurch gekennzeichnet, dass** die genannte Spitze einen Durchmesser aufweist, der größer als oder gleich einem Drittel des Durchmessers des genannten Lochs ist.

6. Vorrichtung gemäß Anspruch 4 oder 5, **dadurch gekennzeichnet, dass** der genannte Punkt einen Durchmesser aufweist, der kleiner als oder gleich drei Vierteln des Durchmessers des genannten Lochs ist.

7. Vorrichtung gemäß einem der voranstehenden Ansprüche, **dadurch gekennzeichnet, dass** das Material des genannten Einstellelements ein metallisches oder semi-isolierendes Halbleitermaterial ist, wie z. B. ein nicht gedoptes Halbleitermaterial.

8. Vorrichtung gemäß einem der voranstehenden Ansprüche, **dadurch gekennzeichnet, dass** sie Mittel zum Verschieben des genannten Einstellelements gemäß der Höhe des genannten Lochs derart umfasst, dass der Abstand zwischen dem genannten Element und dem Boden des genannten Lochs einstellbar ist.

9. Anpassungsverfahren der Frequenz des Modus Terahertz in einer Vorrichtung gemäß Anspruch 8, **dadurch gekennzeichnet, dass** es eine Stufe umfasst, die in der Einstellung der Einführhöhe des Einstellelements in das Loch derart umfasst, dass die gewünschte Frequenz Terahertz erhalten wird.

10. Anpassungsverfahren der Frequenz des Modus Terahertz in einer Vorrichtung gemäß Anspruch 1 bis 8, **dadurch gekennzeichnet, dass** es eine Stufe umfasst, die in der Modifizierung der Größe des Lochs derart besteht, dass die gewünschte Frequenz Terahertz erreicht wird.

11. Verfahren gemäß dem voranstehenden Anspruch, **dadurch gekennzeichnet, dass** die genannte Stufe, die in der Modifizierung der Größe des Lochs besteht, eine Abnahme- oder Hinzufügungsstufe von Material ist.

## Claims

1. A laser device (101) for emitting waves within a frequency range comprised between 0.5 THz and 5 THz comprising a semiconductor heterostructure (102) having a substantially cylindrical shape with a circular cross-section, said heterostructure comprising:

   - a first layer (107) of an optically nonlinear semiconductor material including emitting means (110, 111) able to emit in at least two optical whispering gallery modes belonging to the near infrared, said at least two whispering gallery modes being confined in said first layer (107) and enabling, within said first layer (107) a radiation to be generated in an electromagnetic whispering gallery mode with a frequency comprised between 0.5 THz and 5 THz, called Terahertz mode, said radiation being generated by the difference in frequency of said two whispering gallery modes, the substantially cylindrical geometry of said heterostructure ensuring the phase matching between the two optical whispering gallery modes belonging to the near infrared and the Terahertz mode at the difference in frequency;
   - a second (108) and a third (106) layers of semiconductor material each having a lower optical index than the index of the material used for said first layer (107) and located on either side of said first layer (107);
   - at least one metal layer (103, 104) located at one end of said heterostructure (102);

   said device being **characterised in that**:

   - said heterostructure (102) is provided at the centre thereof with a hole (114) having a substantially cylindrical shape extending along the whole height (h) of said heterostructure (102), the radius of said hole (114) being selected in order to enable the phase matching to be established;
   - the difference between the radius ($R_{ext}$) of the cylinder forming said heterostructure (102) and the radius (Pint) of the hole is greater than

   $$0.05 \times \frac{\lambda_{THz}}{\eta_{THz}}$$ where $\lambda_{THz}$ is the emission wavelength in the frequency range comprised between 0.5 THz and 5 THz and $\eta_{THz}$ is the effective propagation index of the Terahertz mode at the wavelength $\lambda_{THz}$;
   - the device comprises a setting element (117) made of a low absorbing material in the frequency range comprised between 0.5 THz and 5 THz, said setting element (117) having a size smaller than that of said hole (114) and being inserted in said hole.

2. The device (101) according to the preceding claim, **characterised in that** said semiconductor heterostructure (102) rests on a base plate able to cool said heterostructure.

3. The device (101) according to one of the preceding claims, **characterised in that** said emitting means are selected from quantum boxes, quantum cascade structures and quantum wells advantageously having different thicknesses.

4. The device (101) according to one of the preceding claims, **characterised in that** said element (117) is a tip having a substantially cylindrical shape with a circular cross-section.

5. The device according to the preceding claim, **characterised in that** said tip has a diameter equal to or greater than one third of the diameter of said hole.

6. The device according to one of claims 4 or 5, **characterised in that** said tip has a diameter equal to or smaller than the three quarters of the diameter of said hole.

7. The device according to one of the preceding claims, **characterised in that** the material of said setting element is a metal material or a semiinsulating semiconductor material such as a non-doped semiconductor material.

8. The device according to one of the preceding claims, **characterised in that** it comprises means for moving said setting element along the height of said hole so that the gap between said element and the bottom of said hole can be set.

9. A method for adjusting the frequency of the Terahertz mode in a device according to claim 8, **characterised in that** it comprises a step of setting the height of insertion of the setting element into the hole in order to obtain the wanted Terahertz frequency.

10. The method for adjusting frequency of the Terahertz mode in a device according to one of claims 1 to 8, **characterised in that** it comprises a step of changing the size of the hole in order to obtain the wanted Terahertz frequency.

11. The method according to the preceding claim, **characterised in that** said step of changing the size of the hole is a step of removing or adding material.

**Fig. 1**

**Fig. 2**

**Fig. 5**

**Fig. 3**

**Fig. 4**

**Fig. 6**

**Fig. 7**

**Fig. 8**

Fig. 9a

2. collage sur un substrat hôte

1. dépôt du miroir inférieur

Fig. 9b

Fig. 9c

3. Retrait du substrat de croissance et de la couche sacrificielle

Fig. 9d

4. Lithographie, dépôt du miroir
supérieur et du masque dur, lift-off

212    211

210    203
204
205
206
207
208
209

**Fig. 9e**

5. Gravure et retrait du
résidu de masque dur

103

109
108
107
106
103
104
209

102

**Fig. 9f**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2932616

**Littérature non-brevet citée dans la description**

- **M. TONOUCHI.** Cutting-edge terahertz technology. *Nature Photonics,* Février 2007, 97
- **M. KOCH.** Terahertz technology : a land to be discovered. *Optics and Photonics News,* Mars 2007, 21
- **D. MITTLEMAN.** Sensing with Terahertz Radiation. Springer-Verlag, 2003
- **E. R. BROWN et al.** Photomixing up to 3,8 THz in low-temperature-grown GaAs. *Appl. Phys. Lett.,* 1995, vol. 66, 285
- **S. VERGHESE et al.** Generation and detection of coherent terahertz waves using two photomixers. *Appl. Phys. Lett.,* 1998, vol. 73, 3824
- **R. KOHLER et al.** Terahertz semiconductor-heterostructure laser. *Nature,* 2002, vol. 417, 156

- **L. AGGARWAL et al.** Noncolinear phase matching in GaAs. *Appl. Phys. Lett.,* 1973, vol. 22, 239
- **K. H. YANG et al.** Generation of Far-Infrared Radiation by Picosecond Light Pulses in LiNbO3. *Appl. Phys. Lett.,* 1971, vol. 19, 320
- **Y.-S. LEE et al.** Generation of narrow-band terahertz radiation via optical rectification of femtosecond pulses in periodically poled lithium niobate. *Appl. Phys. Lett.,* 2000, vol. 76, 2505
- **K. L. VODOPYANOV et al.** Terahertz-wave generation in quasi-phase-matched GaAs. *Appl. Phys. Lett.,* 2006, vol. 89, 141119
- **V. BERGER ; C. SIRTORI.** Nonlinear phase matching in THz semiconductor waveguides. *Semicond. Sci. Technol.,* 2004, vol. 19, 964